# EUROPEAN PATENT APPLICATION

(11) **EP 2 463 902 A1**
(43) Date of publication of application: **13.06.2012**
(21) Application number: 09848016.3
(22) Date of filing: 04.08.2009
(51) Int. Cl.: H01L 23/36, H01L 23/373, H01L 33/00

(54) **HEAT SINK AND METHOD FOR MANUFRACTURING THE HEAT SINK**

(71) Applicant: Yoshida, Naohiro, Saitama 363-0027 (JP)
(72) Inventor: Yoshida, Naohiro, Saitama 363-0027 (JP)
(74) Representative: Feldkamp, Rainer
(86) International application number: PCT/JP2009/003726
(87) International publication number: WO 2011/016083

(57) **Abstract**

A heat sink of the present invention includes an arbitrarily shaped carbon material (1) having a property of diffusing heat in plate surface directions, the carbon material (1) having a plurality of holes (2) formed therein passing all the way through the carbon material (1) in a thickness direction thereof, a plurality of metal columns (3) formed by filling metal having thermal conductivity in the individual holes (2), and a radiator fin element (4) which is made of the same material as the metal columns (3), including a metal plate portion (4a) and a plurality of fins (4b) formed integrally with the metal columns (3), the metal plate portion (4a) covering at least one surface of the carbon material (1).

## Description

### Field of the Invention

The present invention relates to a heat sink used for cooling electronic components, such as light emitting diode (LED) lamps, and a method of manufacturing the heat sink.

### Background Art

Heat sinks manufactured in various shapes and structures for cooling electronic components are available for practical use today. As an example, Japanese Patent No. 3673436 proposes a metal impregnated carbon composite material for use as a material for a heat sink, in which a metal material like aluminum is impregnated in pores in a carbon material which is compressed into a blocklike shape to form the metal impregnated carbon composite material having an improved thermal conductivity.

### Citation List

### Patent Literature

Japanese Patent No. 3673436.

In the manufacture of the aforementioned metal impregnated carbon composite material of the prior art, however, the pores are not uniformly distributed in the carbon material and, thus, the metal material like aluminum is filled into the irregularly distributed air pores, causing instability of the thermal conductivity. One quality problem that arises when this metal impregnated carbon composite material is used in a heat sink is that the heat sink can not provide a stable heat dissipating property.

### Summary of the Invention

It is an object of the present invention to provide a heat sink which makes it possible to solve the aforementioned problem of the prior art.

According to the present invention, a heat sink includes an arbitrarily shaped carbon material having a property diffusing heat in plate surface directions, the carbon material having a plurality of holes formed therein passing all the way through the carbon material in a thickness direction thereof, a plurality of metal columns formed by filling metal having thermal conductivity in the individual holes, and a radiator fin element which is made of the same material as the metal columns, including a metal plate portion and a plurality of fins formed integrally with the metal columns, the metal plate portion covering at least one surface of the carbon material.

The heat sink of the present invention thus structured makes it possible to uniformly distribute the metal columns in the carbon material. Therefore, even if an LED lamp is mounted on the heat sink, the heat sink can efficiently transmit heat generated by the LED lamp to the radiator fin element provided on one side of the carbon material opposite to a component side thereof, making it possible to achieve a high heat dissipating effect.

### Brief description of the drawings

FIG. 1 is a sectional side view of a heat sink according to a first embodiment of the invention;
FIG. 2 is a perspective view of the heat sink according to the first embodiment;
FIG. 3 is a perspective view of a block of a carbon material;
FIG. 4 is a perspective view illustrating how a rectangular plate-like piece is cut from the carbon material block;
FIG. 5 is a perspective view illustrating how holes are bored in the rectangular plate-like carbon material piece;
FIG. 6 is a sectional side view illustrating a molding process for forming metal columns and a metal plate;
FIG. 7 is a sectional side view illustrating a molding process for forming metal columns and a metal plate in one variation of the first embodiment; and
FIG. 8 is a perspective view illustrating how holes are bored in a carbon material according to a second embodiment of the invention.

### Description of the Embodiments

Heat sinks and manufacturing methods thereof according to the present invention are described in detail with reference to the accompanying drawings hereinbelow.

### First Embodiment

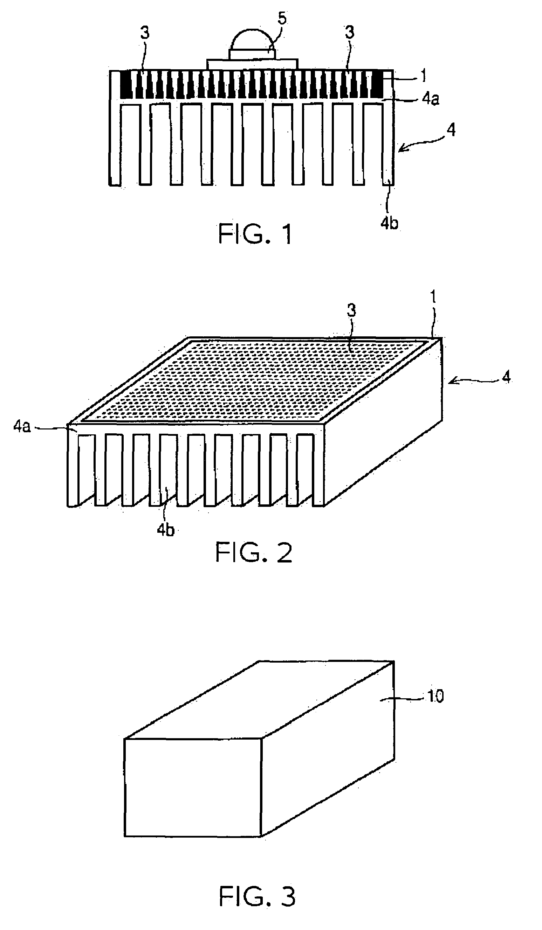

FIG. 1 is a sectional side view of a heat sink according to a first embodiment of the invention, and FIG. 2 is a perspective view of the heat sink according to the first embodiment.

A carbon material (graphite) formed in a rectangular plate-like shape depicted in these Figures has an excellent thermal diffusity which ensures that heat quickly diffuses in plate surface directions (i.e., the directions perpendicular to a plate thickness direction). The carbon material 1 has a large number of small-diameter holes that are distributed generally at uniform pitches throughout the plate surface and pass through the thickness of the carbon material 1. These holes are filled with metal having a high thermal conductivity, such as aluminum, copper or silver, to form a large number of metal columns 3 in the carbon material 1. The metal columns 3 are formed integrally with a radiator fin element 4 having a comb-like cross-sectional shape which is made of the same material as the metal columns 3, including a metal plate portion 4a covering the entirety of one surface of the carbon material 1 and peripheral surfaces thereof as well as a plurality of fins 4b.

The heat sink thus structured has one surface on which the radiator fin element 4 is provided on the carbon material 1 and an opposite surface which is used as a component side. An electronic device 5 like an LED lamp is mounted on the component side of the heat sink (or of the carbon material 1) as depicted in FIG. 1 together with a circuit for driving the electronic device 5. If the electronic device 5 generates heat when driven, the heat quickly spreads through the carbon material 1 in the plate surface directions of the component side thereof and is transmitted to the metal plate portion 4a of the radiator fin element 4 on the opposite side by way of the large number of metal columns 3. The heat is further transmitted to the individual fins 4b and dissipated into a surrounding medium (air). As the metal columns 3 and the radiator fin element 4 are made of such metal as aluminum, copper or silver having a high thermal conductivity as mentioned above, the heat generated by the electronic device 5 is swiftly transferred to the radiator fin element 4, making it possible to efficiently radiate the heat from the electronic device 5.

The heat sink may be so structured that a thin metal plate made of the same material as the metal columns 3 and the radiator fin element 4 is formed integrally therewith on the component side of the carbon material 1.

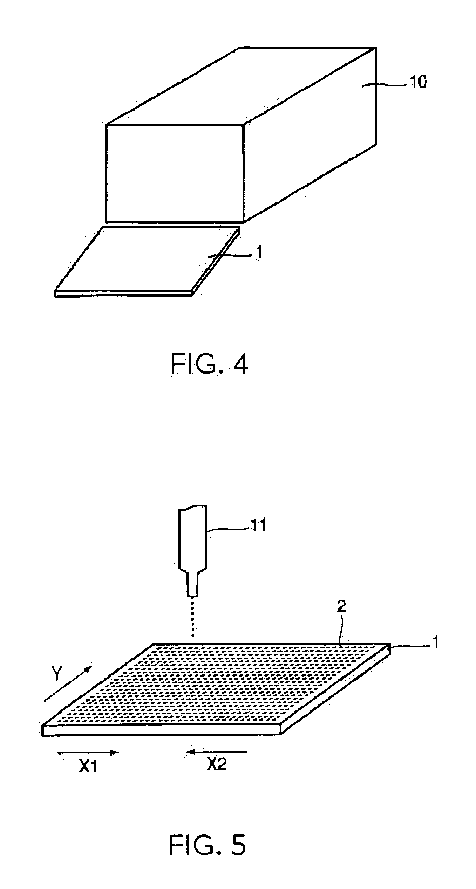

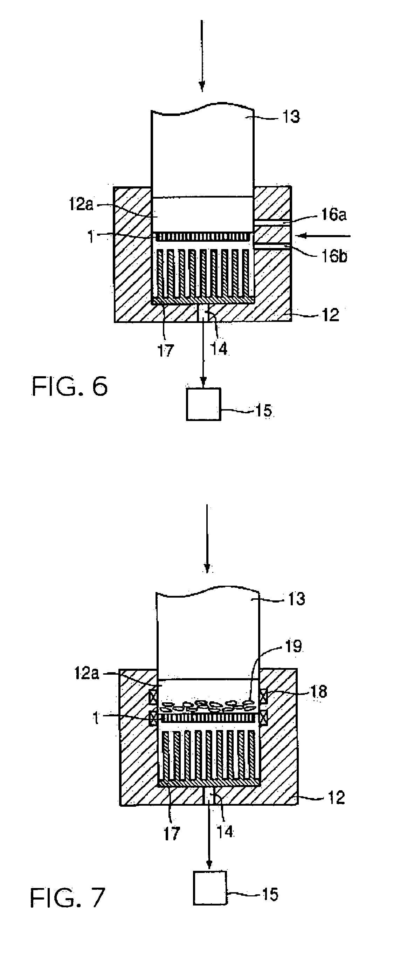

A manufacturing method of the aforementioned heat sink of the first embodiment is now described below. FIG. 3 is a perspective view of a carbon material block 10, FIG. 4 is a perspective view illustrating how a rectangular plate-like piece is cut from the carbon material block 10, FIG. 5 is a perspective view illustrating how holes are bored in the rectangular plate-like carbon material piece,and FIG. 6 is a sectional side view illustrating a molding process for forming the metal columns 3 and the metal plate 4.

First, the carbon material block 10 depicted in FIG. 3 is prepared. The carbon material block 10 is produced by compressing a specific carbon material to form a carbon mass having high density and high heat diffusing performance and cutting a rectangular parallelepiped-shaped block from the carbon mass, for example. Then, as illustrated in FIG. 4, a rectangular plate-like piece is cut from the carbon material block 10 by using a cutting device like a cutting saw (not shown) to form a rectangular plate-like carbon material 1 having a thickness of approximately 2 mm, for example.

This rectangular plate-like carbon material 1 is formed by cutting the carbon material block 10 in such a manner that the carbon material 1 provides an excellent thermal diffusivity to ensure that heat quickly diffuses in the plate surface directions as mentioned earlier. As depicted in FIG. 5, the rectangular plate-like carbon material 1 is irradiated by laser light emitted from a laser light irradiation head 11 which is connected to a laser light source to form a large number of small-diameter holes 2 that are distributed generally at uniform pitches throughout the plate surface and pass through the thickness of the carbon material 1. Preferably, the laser light source is of a type which emits laser light having a wavelength of the near infrared region. The laser light source used in this embodiment is a yttrium-aluminum garnet (YAG) laser (wavelength: 1,064 nanometers), for example.

When irradiating with a laser light, the laser light irradiation head 11 is set in a vertical position and the rectangular plate-like carbon material 1 is mounted at a horizontally fixed position on an unillustrated movable table. The laser light is emitted from the laser light irradiation head 11 while the carbon material 1 is successively moved in front-rear directions (y-axis directions) and left-right directions (x-axis directions) together with the movable table to bore the holes 2 in the carbon material 1. For example, while the carbon material 1 is successively moved in an X1 direction together with the movable table the laser light irradiation head 11 is caused to emit the laser light to bore the holes 2 in one row. The carbon material 1 is then moved by a specified distance in a Y direction together with the movable table. Subsequently, the laser light irradiation head 11 is caused to emit the laser light while the carbon material 1 is moved in an X2 direction opposite to the X1 direction together with the movable table to bore the holes 2 in a next one row, and the carbon material 1 is moved again by the specified distance in the Y direction together with the movable table. The above sequence is repeatedly carried out to form the aforementioned large number of holes 2 in the carbon material 1 passing through the thickness thereof.

The holes 2 formed by laser light irradiation in this way each has a tapered cross-sectional shape with the diameter of an opening on a laser light irradiation side larger than that of an opening on the opposite side. For example, the holes 2 are formed such that each of these tapered holes 2 has a diameter between 0.7 mm and 0.3 mm on the laser light irradiation side and a diameter between 0.3 mm and 0.1 mm on the opposite side, wherein the laser light irradiation side of the carbon material 1 on which each of the holes 2 has the larger diameter constitutes the component side. In a case where aluminum is filled in the holes 2, for instance, the holes 2 should preferably take up approximately 5% to 15% of the entire volume of the carbon material 1.

In a case where another type of thermally conductive metal, such as copper or silver, is filled in the holes 2, however, the thermal diffusivity of the heat sink is determined by varying the amount of heat diffusing carbon and the amount of the thermally conductive metal in relation to the volumetric capacity of the holes 2 as necessary.

It is to be pointed out that the heat sink of the embodiment may be so modified as to employ, instead of the single laser light irradiation head 11, a multilaser-light irradiation head configured by arranging a plurality of laser light irradiation heads 11 which can bore a plurality of rows of holes 2 at the same time. Furthermore, the heat sink may be configured by using the Galvano method, in which a mirror is pivoted to successively direct the laser light along the rows of the holes 2.

Surfaces of the rectangular plate-like carbon metal 1 having the holes 2 thus formed are polished where necessary and, then, the carbon material 1 is set in a mold 12 of a vacuum forming machine. The mold 12 has a recess 12a formed therein that fits on the outer shape of the carbon material 1, the recess 12a having an open end through which a pressing part 13 of a pressurizer is slidably fit. The carbon material 1 is set in the recess 12a of the mold 12 together with a core 17 in such a manner that the component side of the carbon material 1 faces the pressing part 13. The core 17 whose shape is a reversal of the shape of the radiator fin element 4 is positioned so as to be sandwiched between the carbon material 1 and a bottom surface of the recess 12a.

A suction channel 14 and inlet channels 16a, 16b for feeding molten metal into the recess 12a are formed in a peripheral wall of the mold 12. The suction channel 14 is connected to a vacuum pump 15 for creating vacuum within the mold 12 while the inlet channels 16a, 16b are connected to a molten metal feeder (not shown) which melts such metal as aluminum, copper or silver having a high thermal conductivity and feeds the molten metal into the recess 12a.

After the rectangular plate-like carbon material 1 has been set in the recess 12a of the mold 12 of the vacuum forming machine as mentioned above, the pressing part 13 of the presserizer is fit in the open end of the mold 12. Then, the vacuum pump 15 is run to suck air from within the mold 12 to create vacuum in the recess 12a of the mold 12. At the same time, a specified amount of metal melted by the unillustrated molten metal feeder is fed into a side of the pressing part 13 and the core 17 in the recess 12a through the inlet channels 16a, 16b and, then, the suction channel 14 and the inlet channels 16a, 16b are closed by means of solenoid valves or the like (not shown). Subsequently, a mover (not shown) of the unillustrated press forces the pressing part 13 toward the carbon material 1 to apply pressure to the inside of the recess 12a.

Consequently, the molten metal flows into and fill up the individual holes 2 in the carbon material 1 from the component mounting side thereof as well as the space formed between the carbon material 1 and the core 17. As a result of the aforementioned molding process, the metal columns 3 which are tapered are formed in the individual holes 2, and the radiator fin element 4 are formed into the comb-like cross-sectional shape, composed of the metal plate portion 4a, which is formed on the opposite surface of the component mounting surface of the carbon material 1 and the peripheral surfaces of the carbon material 1, and the plurality of fins 4b. The radiator fin element 4 thus formed, so that the present invention makes it possible to manufacture the one-piece molded heat sink of the embodiment.

As stated earlier, the heat sink of the embodiment may be varied such that a thin metal plate made of the same material as the metal columns 3 and the metal plate 4 is formed integrally therewith on the component side of the carbon material 1.

Subsequently, the pressing part 13 is withdrawn from the recess 12a of the mold 12 and the heat sink thus manufactured is taken out of the recess 12a together with the core 17. After removal of the core 17, the heat sink is subjected to a finishing process which includes flash removal and polishing operations to obtain a finished product. If the metal columns 3 and the radiator fin element 4 are molded using a rectangular plate-like carbon material 1 having an area of a plurality of heat sinks, the large-sized rectangular plate-like carbon material 1 carrying the plurality of heat sink sections is removed from the recess 12a of the mold 12 and cut into the individual heat sink sections. Then, the heat sink sections are individually subjected to the finishing process including the flash removal and polishing operations to obtain a plurality of finished heat sinks.

It should be noted that the metal columns 3 and the metal plate 4 may be formed by an alternative manufacturing method which differs from the above-described manufacturing method. FIG. 7 is a sectional side view illustrating a molding process for forming the metal columns 3 and metal plate in one variation of the first embodiment. A mold 12 of a vacuum forming machine used in this molding process does not have the inlet channels depicted in FIG. 6. Instead, the mold 12 is provided with high-frequency induction heating coils 18 wound around a recess 12a formed in the mold 12. The constructions other than the above are the same as those in the FIG. 6.

The rectangular plate-like carbon material 1 is set in the recess 12a formed in the mold 12 in such a manner that the component side of the carbon material 1 faces the pressing part 13 of the unillustrated press. The core 17 is positioned so as to be sandwiched between the carbon material 1 and the bottom surface of the recess 12a in this variation of the embodiment as well. After placing a necessary amount of pieces 19 of meltable metal having a high thermal conductivity, such as aluminum, copper or silver, on the carbon material 1, the pressing part 13 of the press is fit in the open end of the mold 12. Subsequently, the vacuum pump 15 is run to suck air from within the mold 12 to create vacuum in the recess 12a of the mold 12. At the same time, the high-frequency induction heating coils 18 are energized to melt the meltable metal pieces 19. Then, the mover (not shown) of the unillustrated press forces the pressing part 13 toward the carbon material 1 to apply pressure to the inside of the recess 12a while eliminating vacuum created therein.

Consequently, the molten metal flows through the individual holes 2 in the carbon material 1 from the component side thereof and into the opposite side of the carbon material 1, filling up each hole 2 and the space G. As a result of this molding process, the metal columns 3 which are tapered are formed in the individual holes 2 while the component side and the opposite side of the carbon material 1 as well as the radiator fin element 4 are formed. The radiator fin element 4 thus formed has the comb-like cross-sectional shape including the metal plate portion 4a covering the entire one surface of the carbon material 1 and the peripheral surfaces thereof and the plurality of fins 4b. The above-described alternative molding process makes it possible to manufacture the one-piece molded heat sink.

As thus far described, the heat sink of the first embodiment is structured by boring the large number of small-diameter holes 2 that are uniformly distributed throughout the entire plate surface of the rectangular plate-like carbon material 1 through the thickness thereof, forming the large number of metal columns 3 by filling the molten metal having a high thermal conductivity in the individual holes 2, and then forming the radiator fin element 4 having the comb-like cross-sectional shape made of the same material as the metal columns 3 integrally therewith to cover the entirety of one surface of the carbon material 1. Therefore, when the electronic device 5 is mounted on the component mounting surface side of the carbon material 1 that is opposite side of the metal plate portion 4a is provided, the heat sink of the embodiment offers such an advantage that the heat sink can efficiently transmit the heat generated by the electronic device 5 to the radiator fin element 4 through the metal columns 3, thereby providing high heat dissipating performance. Additionally, the first embodiment makes it possible to obtain a composite material having mechanical strength.

Especially when the electronic device 5 is an LED lamp for which heat dissipation is critical, a heat sink employing a metal impregnated carbon composite material of the prior art has not been able to provide a stable heat dissipating effect without quality problems. The heat sink of the foregoing first embodiment is structured by boring the large number of uniformly distributed holes 2 in the plate-like carbon material 1 and forming the large number of metal columns 3 by filling the molten metal having a high thermal conductivity in the individual holes 2 as discussed above. This structure of the embodiment makes it possible to uniformly distribute the metal columns 3 in the carbon material 1. Therefore, even if an LED lamp is mounted on the heat sink, the heat sink can efficiently transmit heat generated by the LED lamp to the radiator fin element 4 which is integrally formed on one side of the carbon material 1 opposite to the component side thereof, making it possible to achieve a high heat dissipating effect.

### Second Embodiment

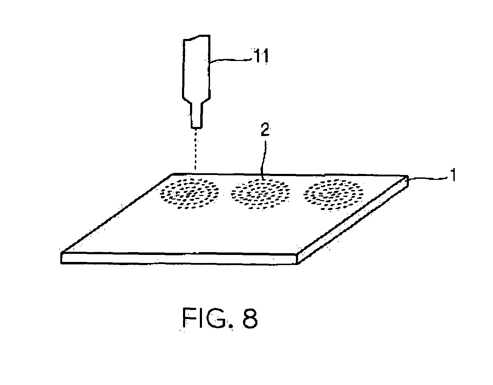

FIG. 8 is a perspective view illustrating how holes are bored in part of a rectangular plate-like piece of a carbon material according to a second embodiment of the invention. The second embodiment is discussed with reference to FIG. 8 hereunder.

According to the second embodiment, a laser light irradiation head 11 emits laser light to a rectangular plate-like carbon material 1 having a relatively large surface area to irradiate part o areas of the carbon material 1 with a laser where electronic components are to be mounted, for example. The laser light irradiation head 11 thus bores a large number of small-diameter holes 2 passing through the thickness of the carbon material 1 in each component mounting area thereof. Metal having a high thermal conductivity, such as aluminum, copper or silver, is filled into the individual holes 2 to form metal columns therein, and a radiator fin element, not illustrated, having a comb-like cross-sectional shape including a metal plate portion and a plurality of fins made of the same material as the metal columns 3 is formed integrally covering the entire one surface of the carbon material 1. The rectangular plate-like carbon material 1, the metal columns and the radiator fin element thus formed together constitute a heat sink of the second embodiment.

According to this embodiment, plurality of radiator fin elements may be formed to cover only portions of the carbon material 1 where the metal columns are formed or to cover the entirety of one surface of the carbon material 1.

While FIG. 8 illustrates an example in which the holes 2 are bored in a spiral pattern in each of the circular component mounting areas of the carbon material 1, the holes 2 may be bored in each component mounting area which is rectangular shaped as in the first embodiment depicted in FIG. 1. In a case where the holes 2 are bored in the spiral pattern, there is made an arrangement that controls a movable table (not shown) for setting the carbon material 1 in a position to successively move along the spiral pattern while boring the holes 2.

In the heat sink thus structured, one surface of the carbon material 1 opposite to the surface on which the metal plate portion is provided is used as a component side of the carbon material 1. An electronic device 5 like an LED lamp is mounted on the component side of the heat sink (or of the carbon material 1) together with a wiring necessary for driving the electronic device 5. If the electronic device 5 thus mounted on the carbon material 1 generates heat when driven, the heat quickly spreads through the carbon material 1 in plate surface directions of the component side thereof and is transmitted to the radiator fin element 4 on the opposite side of the component side by way of the large number of metal columns in the carbon material 1 to be dissipated into a surrounding medium (air). As the metal columns and the radiator fin element 4 are made of such metal as aluminum, copper or silver having a high thermal conductivity as mentioned above, the heat generated by the electronic device 5 is efficiently transferred to the radiator fin element 4 to be dissipated from the electronic device 5.

The heat sink of the second embodiment can be produced by the same manufacturing method as described in the first embodiment. In a case where the metal plate portion is only provided at the portion of the carbon material 1 where the metal columns are formed, however, a correspondingly shape core should be placed in order to cover part of the carbon material 1 other than the individual portions where the radiator fin element is formed.

Also, if aluminum is filled in the holes 2 in each component mounting area of the carbon material 1, for instance, the holes 2 should preferably take up approximately 5% to 15% of the entire volume of the carbon material 1 in this second embodiment as well.

In a case where another type of thermally conductive metal, such as copper or silver, is filled in the holes 2, however, the thermal diffusivity of the heat sink is determined by varying the amount of heat diffusing carbon and the amount of the thermally conductive metal in relation to the volumetric capacity of carbon material as necessary.

It is to be pointed out that the heat sink of this embodiment may be so modified as to employ, instead of the single laser light irradiation head 11, a multilaser-light irradiation head configured by arranging a plurality of laser light irradiation heads 11 which can bore a plurality of rows of holes 2 at the same time. Furthermore, the heat sink may be configured by using the Galvano method, in which a mirror is pivoted to successively direct the laser light along the rows of the holes 2.

The above-described second embodiment provides the same advantage as the first embodiment. The heat sink of the second embodiment is structured by boring the holes 2 in each component mounting area of the carbon material 1 and forming the metal columns by filling the metal having a high thermal conductivity in the individual holes 2 as discussed above. This structure of the embodiment makes it possible to mount such electronic components, that need not be cooled together with wirings and the like in areas of the carbon material 1 other than the component mounting areas thereof. It is therefore possible to use the heat sink as a circuit board.

While foregoing first and second embodiments have been described as employing a radiator fin element having a comb-like cross-sectional shape, the invention is not limited thereto. What is essential in this invention is that the radiator fin element is configured to include a metal plate portion and a plurality of fins, therefore other shapes may be used.

Moreover, while the foregoing discussion of the first and second embodiments has dealt with the heat sink on which a heat-generating electronic device like an LED lamp is mounted, the heat sink of the invention is also effective for cooling such kind of electronic device as a concentrating solar cell which itself does not generate heat but is heated by concentrated light, for example.

### List of Reference Signs

- 1: carbon material
- 2: holes
- 3: metal column
- 4: radiator fin element
- 4a: metal plate portion
- 4b: fins electronic device
- 10: carbon material block
- 11: laser light irradiation head
- 12: mold
- 13: pressing part
- 14: suction channel
- 15: vacuum pump
- 16a, 16b: inlet channel
- 17: core
- 18: high-frequency induction heat coils
- 19: piece of meltable metal.

## Claims

1. A heat sink comprising:
an arbitrarily shaped carbon material having a property of diffusing heat in plate surface directions, said carbon material having a plurality of holes formed therein passing through said carbon material in a thickness direction thereof;
a plurality of metal columns formed by filling metal having thermal conductivity in the individual holes; and
a radiator fin element which is made of the same material as said metal columns including a metal plate portion and a plurality of fins formed integrally with said metal columns, the metal plate portion covering at least one surface of said carbon material.

2. The heat sink according to claim 1, wherein said carbon material has a rectangular plate-like shape and said radiator fin element is formed to cover the entirety of one surface of said carbon material.

3. The heat sink according to claim 1, wherein said carbon material has a rectangular plate-like shape, said metal columns are formed in an area of said carbon material where an electronic component is mounted, and said radiator fin element is formed at least in the electronic component mounting area on a side of said carbon material opposite a component side thereof on which the electronic component is mounted.

4. A method of manufacturing a heat sink comprising the steps of:
irradiating an arbitrarily shaped carbon material having a property of diffusing heat in plate surface directions with laser light to form a plurality of holes in said carbon material passing all the way therethrough in a thickness direction thereof;
placing said carbon material in a mold together with a core;
applying pressure to the inside of said mold while feeding molten metal having thermal conductivity into said mold to fill the individual holes in said carbon material in order to form metal columns therein; and
forming a radiator fin element including a metal plate portion and a plurality of fins integrally with said metal columns by means of said core to cover at least one surface of the said carbon material.
